# EUROPEAN PATENT APPLICATION

(11) **EP 2 244 317 A1**
(43) Date of publication of application: **27.10.2010**
(21) Application number: 09158618.0
(22) Date of filing: 23.04.2009
(51) Int. Cl.: H01L 51/52

(54) **Optoelectric device and method for manufacturing the same**

(71) Applicant: Nederlandse Organisatie voor Toegepast -Natuurwetenschappelijk Onderzoek TNO, 2628 VK Delft (NL); Koninklijke Philips Electronics N.V., 5621 AE Eindhoven (NL)
(72) Inventor: Lifka, Herbert, 5691 LP Son en Breugel (NL); Van de Weijer , Peter, 5591 PW Heeze (NL); Van Mol, Antonius Maria Bernardus, 5658 HC Eindhoven (NL)
(74) Representative: Hatzmann, Martin

(57) **Abstract**

A method is described for manufacturing an optoelectric device comprising the steps of
- providing (S1) a layer (10) of an optoelectric active material between a first electrode (22) and a second electrode (32),
- providing (S2) a patterned electrically insulating layer structure (60) at at least one of said electrodes (32), the patterned electrically insulating layer structure (60) having openings (62),
- providing (S3) an electrolyte (70) in said openings (62),
- depositing (S3) a metallic layer in said openings from the electrolyte by electroplating,
**characterized in that** the electrolyte (70) is formed by an ionic liquid.

## Description

### BACKGROUND OF THE INVENTION

### Field of the invention

The present invention relates to a method for manufacturing an optoelectric device. The present invention further relates to an optoelectric device.

### Related Art

Optoelectric devices are devices that that source, detect or control light. Examples are LEDs, photovoltaic cells, and electrochromic devices. These devices require electrical conducting layers, at least one of which is transparent, so that light generated by the optoelectric active layer of the device can be emitted to the environment or light from the environment can reach the optoelectric active layer. For large area LEDs, such as large area OLED lighting on flexible plastic substrates, a large current is required to drive the system. The present thin film materials used for the anode (e.g. ITO) and cathode (e.g. Ba/Al) have a large resistivity and the large currents give rise to substantial voltage drop, which on its turn causes an inhomogeneous light emission. For producing large area flexible OLED devices on plastic substrates there is a need for an additional metallization structure of the plastic substrate. For reducing the manufacturing costs, such structured metallization coatings will preferably be applied on rolls of plastic foil using an inline roll-to-roll web coating process. Accordingly, for (O)LEDs but also for other optoelectric devices, such as electro-chromic devices, and photo-voltaic products there is a need for a metallization structure that on the one hand has a good electrical conductivity, while on the other hand has a high transmission for radiation. According to state-of-the-art roll-to-roll web coating techniques, a system for full metallization or patterned metallization areas of a continuous substrate has been reported.

A known method for applying a metallization structure is to apply the metal lines with evaporation, while defining the structure with a shadowmask. This method is cumbersome and slow as in practice after applying a few hundred nm of the metallization structure the shadow mask has to be cleaned, while a thickness of several µm, e.g. 5 to 20 µm is desired. In order to still achieve a sufficient conduction the metallization structure has to be applied with relatively large linewidths, which is unfavorable when shunting transparent electrodes. Furthermore, the shadowmask requires a 3D construction in order to make it possible that both the shadow mask is a single connected structure and the metal shunting applied therewith is a single connected structure.

Another known method is described in W02007/036850. According to the method described therein a barrier layer structure having first openings is formed over a first face of a structure comprising an electroactive material between a first electrode and a second electrode. As the barrier layer structure can have a relatively modest thickness it can be efficiently deposited with evaporation. Subsequently a plating base is deposited upon the barrier layer structure. The plating base contacts contact areas of the electrodes. A patterned insulator having second openings is applied upon said barrier layer structure with the plating base so that the second openings are aligned with the first openings. Within the openings a metal conductor is electroplated that contacts the plating base. During electroplating the structure with the barrier layer structure, the plating base and the resist layer is lowered into an electroplating bath containing suitable ions such as Cu ions. The barrier layer structure and the plating base efficiently prevent any contact between the liquid, mainly water, of the electroplating bath and the structure. This is necessary as the material used for the cathode may be corroded by the liquid. Even if the electrode itself is not corroded it does not provide sufficient protection to the underlying organic materials. By the process of electroplating within the structure defined by the patterned insulator, an electrically conductive shunting structure is obtained that can have a relatively large height in comparison to their width. In this way the electrically conductive structure has a good conductivity, while having a good overall transparency for light.

There is a need to manufacture an optoelectric device with a reduced number of steps.

### SUMMARY OF THE INVENTION

According to an aspect of the present invention a method is provided for manufacturing an optoelectric device comprising the steps of
- providing a layer of an optoelectric active material between a first electrode and a second electrode,
- providing a patterned electrically insulating layer structure at at least one of said electrodes, the patterned electrically insulating layer having openings,
- providing an electrolyte in said openings,
- depositing a metallic layer in said openings from the electrolyte by electroplating,
**characterized in that** the electrolyte is formed by an ionic liquid.

As an ionic liquid is used as the electrolyte, a solvent, such as water, is not necessary. Therewith it is not necessary that the structure comprising the optoelectric material is protected against the solvent. Accordingly the required metal for the shunting structure may be deposited directly from the ionic liquid at the electrode. Therewith intermediate steps like applying a plating base are obviated. Moreover, the direct contact between the shunting structure and the electrode is favorable for electrical conduction. Although the deposition process may initially be relatively slow it rapidly accelerates once a small amount of metal is deposited at the electrode. It is an additional advantage that in this way materials, such as aluminum, may be deposited that could not be deposited from aqueous solutions. Although the method according to the present invention is particularly useful where the optoelectric material is an organic material, alternatively an inorganic material may be applied as the optoelectric material.

Additional layers may be present between the cathode and the shunting structure. In an embodiment, for example, the cathode is covered by a layer of a wide bandgap semiconductor. Calcium is preferred as a metal for the cathode because of its relatively high optical transmissivity for a metal and because of its proven ability to form a good electron injecting contact to materials. ZnSe, ZnS or an alloy of these materials are the preferred semiconductors because of their good conductivity parallel to the direction of light emission, their ability to protect the underlying low work function metal and organic films and their transparency to the emitted light.

In addition to providing the at least one electrode with a shunting structure in this way, also the other electrode may be provided with a shunting structure. It is not necessary that the method described above is used for applying the shunting structure for the other electrode in case said other electrode is provided before the at least one layer of optoelectric active material is applied. In that case the other electrode may be applied by conventional electroplating, for example by electroplating a layer of silver or copper.

In an embodiment the patterned electrically insulating layer structure is defined by a shadow mask. The electrically insulating layer structure can be relatively thin (e.g. 100 a 200 nm) so that it can be efficiently deposited by a CVD process. The required shadow mask can be a 2D connected structure.

In an embodiment the electrically insulating layer structure is applied by printing. As the metallic layer in the openings of the electrically insulating layer is formed by an ionic liquid, it is not necessary that the electrically insulating layer also has a barrier function. This makes it possible to use a printing technique, such as screen printing, inkjet printing, jet-printing, gravure printing, offset printing.

In an embodiment the patterned electrically insulating layer structure is a barrier layer structure. This has the advantage that the electrically insulating layer structure serves a double function. During manufacturing it serves to define the shape of the metallic layer that is applied from the ionic liquid and in the finished product it protects the optoelectric active material. To provide for a good barrier function the patterned electrically insulating layer structure forming the barrier layer structure may comprise a sequence of layers, in particular a sequence of inorganic layers or inorganic layers separated by organic layers.

In another embodiment a barrier layer structure is applied on top of the metallic layer. In that embodiment it is not necessary that the patterned electrically insulating layer structure is a barrier layer structure. Likewise a barrier layer structure on top of the metallic layer may comprise a sequence of layers, in particular a sequence of inorganic layers or inorganic layers separated by organic layers.

In a further embodiment a further layer of an optoelectric active material sandwiched between a first further electrode and a second further electrode is provided wherein the first further electrode is applied at the patterned electrically insulating layer structure with the metallic layer. In this way a series connection of OLEDs may be realized.

In a first variant of said embodiment both the layer of an optoelectric active material and the further layer of an optoelectric active material are a light-emitting layer. In this way two light emitting devices are arranged in series, therewith enabling a doubling of the light-output with the same supply current. If desired more light emitting devices may be stacked in this way.

Also hybrid optoelectric devices may be constructed in this way. In a second variant of the embodiment having a further layer of an optoelectric active material, the layer of an optoelectric active material is a light-emitting layer and the further layer of an optoelectric active material is a photo-voltaic layer. In a third variant the layer of an optoelectric active material is a light-emitting layer and the further layer of an optoelectric active material is an electrochromic layer.

The second and the third variant are particularly suitable in a window pane or a signage device. The second variant can be used at day-time in a first mode as an energy source that converts a part of the incoming light in electric energy, therewith at the same time tempering the intensity of the incoming light. At night-time the pane can be used in a second mode as a light source. The light emitting layer may be patterned, e.g. in a window pane used as a signage device. The metallic layer is efficiently used as it serves as common electric supply conductor. In the first mode it serves as a power supply line from the photo-voltaic layer to outside the pane. In the second mode it serves as a power supply line towards the light-emitting layer

In said third variant the electrochromic layer allows for a more controllable tempering of the incoming light, The combination of electrochromic layer and the light-emitting layer make it possible provide a window pane that provides for a controllable amount of light, e.g. to supply a constant intensity regardless the time of the day. Also in this variant the metallic layer serves as common electric supply conductor, in this case for the light-emitting layer and for the electrochromic layer.

### BRIEF DESCRIPTION OF THE DRAWINGS

These and other aspects are described in more detail with reference to the drawing. Therein:
Figure 1 shows a basic structure of an optoelectric device,
Figure 2 shows a semifinished product obtained by a conventional method,
Figure 3 schematically shows an embodiment of a method according to the present invention,
Figure 4 shows a semifinished product obtained with the first and the second step of this method,
Figure 5 shows in more detail the third step of the method shown in Figure 3,
Figure 6 shows the semifinished product obtained with this third step,
Figure 7 shows a top-view of the metallic layer obtained with this third step according to VII in Figure 6,
Figure 7A shows a detail of the metallic layer according to 7A in Figure 7,
Figure 7B shows a corresponding detail of a metallic layer obtained in another embodiment of the method,
Figure 8 shows the product obtained after a fourth step of the method is applied,
Figure 9 shows a two optoelectric devices stacked upon each other, at least one of which is obtained by the method according to Figure 3.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.
Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.. In case of conflict, the present specification, including definitions, will control. In addition, the materials, methods, and examples are illustrative only and not intended to be limiting.

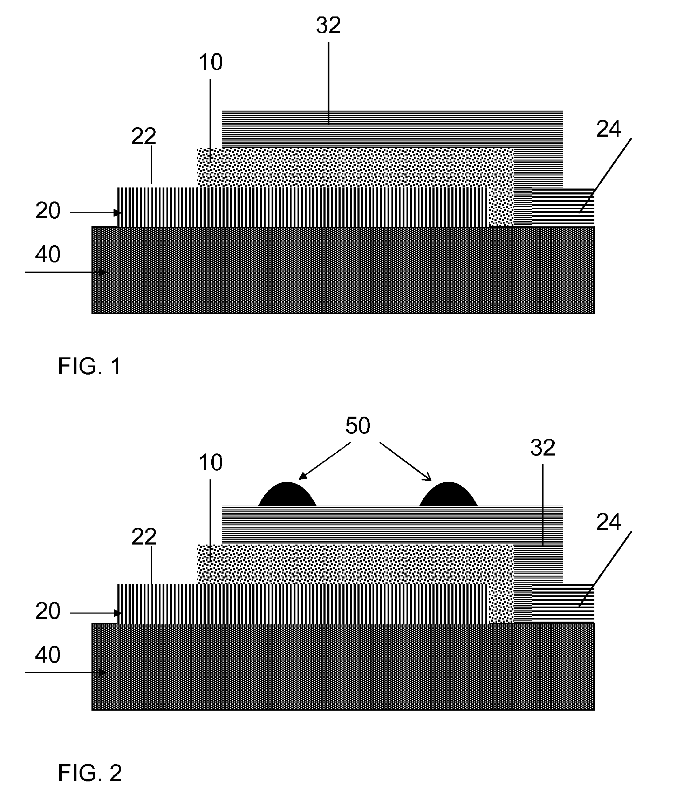

Figure 1 shows a basic structure of an optoelectric device. The device comprises a layer of an optoelectric active material 10 that is sandwiched between a first electrode 22 and a second electrode 32. The first electrode 22 is formed by a first portion of an electrically conductive layer 20 that is applied at a substrate 40. The electrically conductive layer comprises a second portion 24 that is electrically insulated from the first portion 22. The second electrode 32 extends over this second portion 24 of the electrically conductive layer 20.
Figure 2 shows schematically shows a result of a known method, wherein a metallization structure 50 is applied by vapor deposition through a shadow mask. This known method is not attractive as it can in practice only be used to deposit a layer of a few hundred nm of the metal, while a layer in the order of a few µm or more is desired.

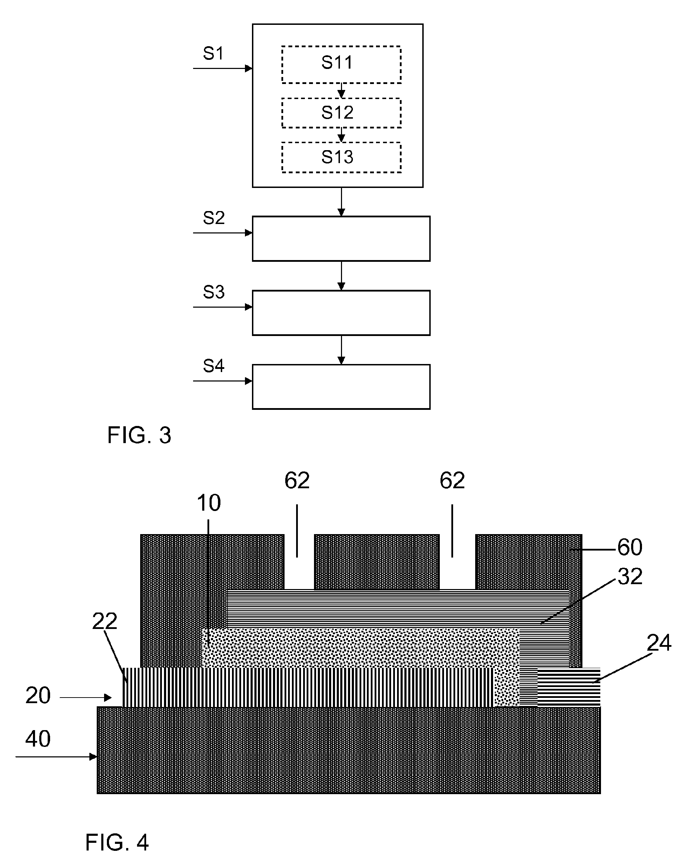

An embodiment of a method according to the present invention is schematically illustrated in Figure 3. The embodiment of the method illustrated therein comprises a first step S1 wherein a layer of an optoelectric active material is applied between a first electrode and a second electrode. This first electrode is usually the anode, as it can have a high work-function. This facilitates further processing steps. In some processes the cathode may be applied as the first electrode, for example in processes using doped small molecule OLED materials. The first step S1 comprises a first substep S11 of providing the first electrode e.g. at a substrate a second substep S12 of providing the layer of optoelectric active material and the third substep S13 of providing the second electrode. The first electrode, e.g. the anode, may be applied for example by wet chemical electro deposition, sputtering, printing methods etc. The optoelectric active material, or a stack of materials may be applied by printing techniques for example. Vapor deposition, e.g. physical vapor deposition is the preferred way to apply the cathode. The embodiment shown in Figure 3 further comprises a second step S2. The result of the first and the second step is shown in Figure 4. In the second step S2 a patterned electrically insulating layer structure 60 is applied at at least one of said electrodes 32, here the cathode. It is not necessary that the patterned electrically insulating layer structure 60 is applied directly upon said electrode. One or more intermediate layers may be applied at the at least one of said electrode. In this case for example a semiconducting layer may be applied at the cathode 32 before applying the patterned electrically insulating layer structure. The patterned electrically insulating layer structure 60 that is deposited has openings 62 that leave free portions of the at least one of the electrodes, here the second electrode 32. Various options are possible to deposit the patterned electrically insulating layer structure 60, e.g. the layer may be applied as a continuous layer which is subsequently patterned, e.g. by etching or by imprinting. Alternatively the layer may be directly applied in its patterned form, e.g. by printing. Most preferably the layer is applied by evaporation, e.g. by a CVD process, such as thermal chemical vapour deposition (CVD), photo assisted chemical vapour deposition (PACVD), plasma enhanced chemical vapour deposition (PECVD), etc and patterned using a mask.

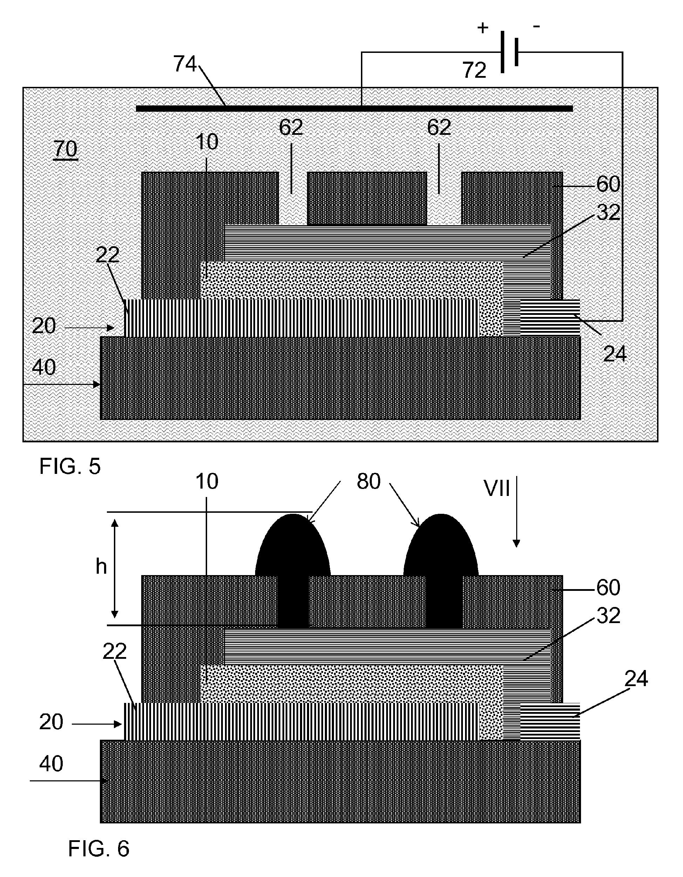

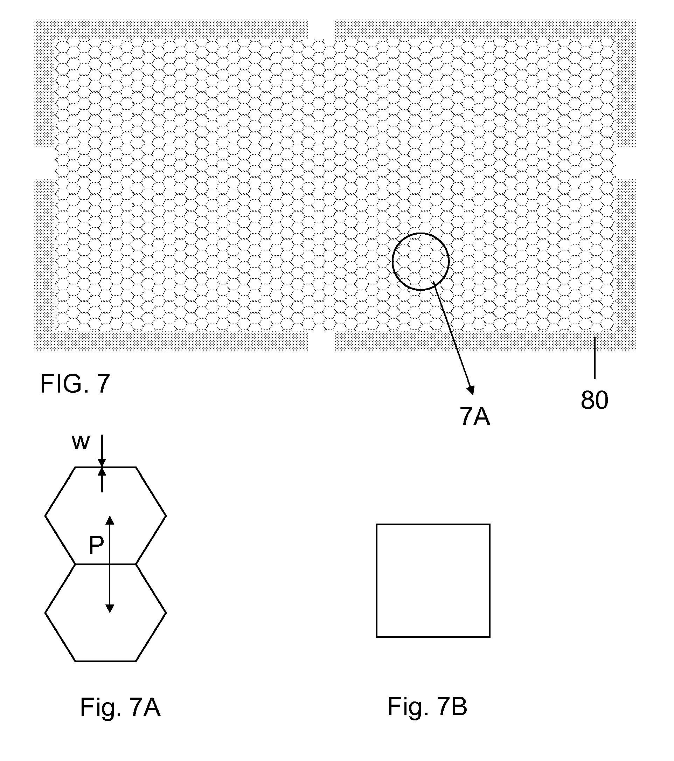

The embodiment further comprises a third step S3. This execution of this step S3 is shown in detail in Figure 5, while its result is shown in Figure 6. As shown in Figure 5 the intermediate product shown in Figure 4 is submerged in a bath comprising an ionic liquid 70. Therewith the electrolyte 70 is provided in the openings 62 of the patterned electrically insulating layer structure 60. In step S4 a metallic layer 80 is deposited at the free portions of the second electrode 32 by electroplating from an ionic liquid 70. To that end the electrode 32 to be provided with the metallic deposition is coupled to a negative pole of a battery 72. The positive pole of a battery is coupled to an auxiliary electrode 74. Instead of submerging the semifinished product in a bath with an ionic liquid, the ionic liquid may be rolled out over the surface and brought into contact with the auxiliary electrode 74. After carrying out step S4 the metallic layer 80 that is deposited at the free portions of the second electrode 32 forms a metal structure 80. This is schematically illustrated in Figure 7 according to top-view VII in Figure 6. Figure 7A shows a detail of this structure according to 7A in Figure 7. In the embodiment shown the metal structure 80 is deposited directly at the free portions of the second electrode 32 (shown in fig. 6). The metal deposition process may continue until the metal structure 80 has a height h in the order of a few µm to a few tens of µm, e.g. about 10 µm. Although the metal structure also grows in the lateral direction, the lateral dimensions remain small enough to be substantially invisible. For example the patterned electrically insulating layer structure 60 (shown in fig. 6) may have grooves having a width in the order of 50 to 100 µm that are mutually spaced at a distance of a few mm. Taking into account that the metal structure grows substantially isotropically, the structure will have a width w in the range of 70 to 120 µm in this example and a pitch P of a few mm, e.g. 3 mm as is shown schematically in Figure 7A. The metal structure 80 herewith is substantially invisible to the human eye and will only absorb a minor fraction of radiation generated by the optoelectric device in case of an OLED or of in case of an photovoltaic device, radiation impingent from the environment. Instead of a hexagonal structure as shown in Figures 7, 7A, also other structures may be used, e.g. the rectangular structure of Figure 7B.

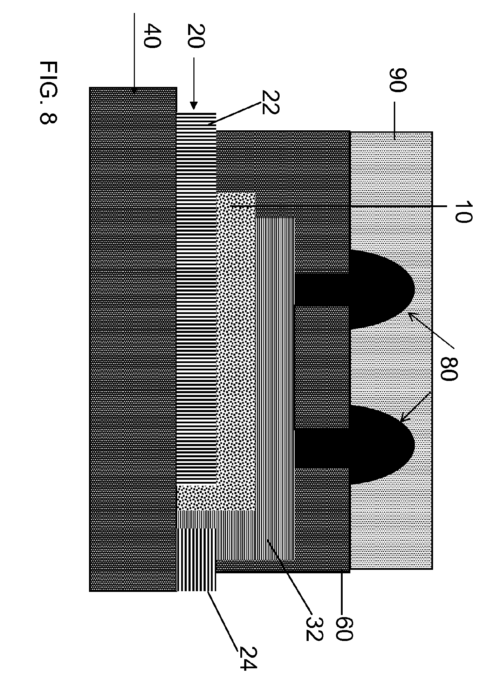

Step S3 may be followed by a further step S5, wherein a barrier layer structure 90 is applied on top of the metallic layer. Therewith the result shown in Figure 8 is obtained. The barrier layer structure 90 may comprise a sequence of inorganic layers, such as the sequence SiN,SiO,SiN,SiO,SiN, also denoted as NONON. Alternatively, the structure may comprise a sequence of alternating organic and inorganic layers, e.g. an organic layer that is sandwiched between a first and a second inorganic layer. The patterned electrically insulating layer structure may also comprise such sequence of inorganic layers or inorganic layers and organic layers. The barrier layer structure 90 may be applied in addition to a barrier layer structure formed by the electrically insulating layer structure 60. Alternatively, when a barrier layer structure 90 is applied the electrically insulating layer structure 60 does not need to have a barrier function. In that case for example a single layer of an organic material may be used for the electrically insulating layer structure 60.

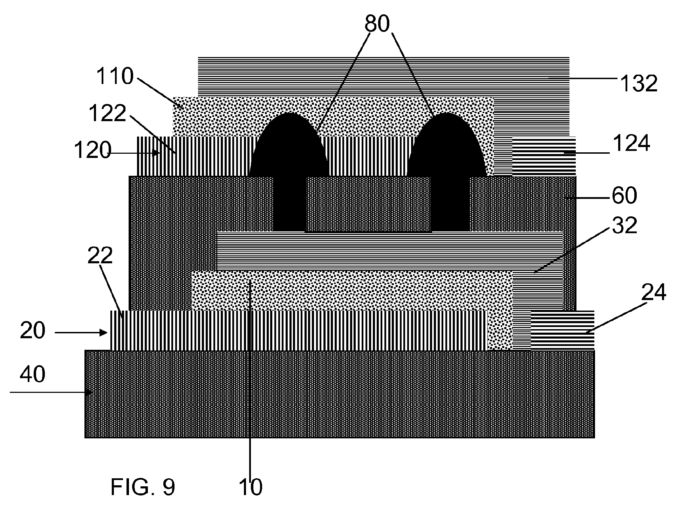

As shown in Figure 9, the metal structure 80 may be used as a contact to a further optoelectric device that is applied upon the optoelectric device formed by steps S1-S3 as shown in Figure 6. In accordance therewith, in a step S5 a further layer of an optoelectric active material 110 is sandwiched between a first further electrode 122, which is formed by a further electrically conductive layer 120, and a second further electrode 132. This second further electrode 132 is electrically connected to a portion 124 of the further electrically conductive layer 120. The optoelectric active material may be an organic or an inorganic material. Organic materials have the advantage that they can be processed at a low temperature. The first further electrode 122 is applied at the patterned electrically insulating layer structure 60 with the metallic layer 80. After completion of step S5, steps S2 and S3 may be repeated so that also the further optoelectric device has a shunt structure. As might be clear the process described in fig 9 can be repeated several times and also several different electro-optical devices can stacked on top of each other.

The following combinations of a layer 10 of an opto-electric active material and a further layer of an opto-electric active material 110 are particularly useful.

In a first variant both the layer 10 of an organic optoelectric active material and the further layer 110 of an optoelectric active material are a light-emitting layer. In this way two light emitting devices are arranged in series, therewith enabling a doubling of the light-output with the same supply current. If desired more light emitting devices may be stacked in this way.

Also hybrid optoelectric devices may be constructed in this way. In a second variant the layer 10 is a light-emitting layer and the further layer 110 is a photo-voltaic layer. In a third variant the layer 10 is a light-emitting layer and the further layer 110 is an electrochromic layer.
The second and the third variant are particularly suitable in a window pane or a signage device. The second variant can be used at day-time in a first mode as an energy source that converts a part of the incoming light in electric energy, therewith at the same time tempering the intensity of the incoming light. At night-time the pane can be used in a second mode as a light source. The light emitting layer 10 may be patterned, e.g. in a window pane used as a signage device. The metallic layer 120 is efficiently used as it serves as common electric supply conductor. In the first mode it serves as a power supply line from the photo-voltaic layer 110 to outside the pane. In the second mode it serves as a power supply line towards the light-emitting layer 10. In the third variant the electrochromic layer 110 allows for a more controllable tempering of the incoming light, as compared to a photo-voltaic layer. The combination of electrochromic layer 110 and the light-emitting layer 10 make it possible provide a window pane that provides for a controllable amount of light, e.g. to supply a constant intensity regardless the time of the day. Also in this variant the metallic layer 120 serves as common electric supply conductor, in this case for the light-emitting layer 10 and for the electrochromic layer 110.

It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. Method for manufacturing an optoelectric device comprising the steps of
- providing (S1) a layer of an optoelectric active material between a first electrode and a second electrode,
- providing (S2) a patterned electrically insulating layer structure at at least one of said electrodes, the patterned electrically insulating layer structure having openings,
- providing (S3) an electrolyte in said openings,
- depositing (S4) a metallic layer in said openings from the electrolyte by electroplating,
**characterized in that** the electrolyte is formed by an ionic liquid.

2. Method according to claim 1, wherein the patterned electrically insulating layer structure is a barrier layer structure.

3. Method according to claim 1 or 2, **characterized in that** the patterned electrically insulating layer structure is defined by a shadow mask.

4. Method according to claim 1, wherein the patterned electrically insulating layer structure is defined with a printing technique.

5. Method according to claim 1 or 2, wherein a barrier layer structure is applied on top of the metallic layer.

6. Method according to claim 1, wherein a further layer of an optoelectric active material sandwiched between a first further electrode and a second further electrode is provided wherein the first further electrode is applied at the patterned electrically insulating layer structure with the metallic layer.

7. Optoelectric device comprising
- a layer (10) of an optoelectric active material between a first electrode (22) and a second electrode (32),
- a patterned electrically insulating layer structure (60) at at least one of said electrodes (32), the patterned electrically insulating layer structure having openings (62)
- a metallic structure (80) at the patterned electrically insulating layer structure (60) that extends through the openings (62) and therein directly contacts free portions of the at least one of the electrodes (32) in front of said openings (62).

8. Optoelectric device according to claim 7, comprising a stack with a further layer (110) of an optoelectric active material between a third electrode (122) and a fourth electrode (132), said stack (110, 132, 122) being arranged at the patterned electrically insulating layer structure (60) with the metallic structure (80).

9. Optoelectric device according to claim 8, wherein both the layer (10) of an optoelectric active material and the further layer (110) of an optoelectric active material is a light-emitting layer.

10. Optoelectric device according to claim 8, wherein the layer (10) of an optoelectric active material is a light-emitting layer and the further layer (110) of an optoelectric active material is a photo-voltaic layer.

11. Optoelectric device according to claim 8, wherein the layer (10) of an optoelectric active material is a light-emitting layer and the further layer (110) of an optoelectric active material is an electrochromic layer.
